# EUROPÄISCHE PATENTSCHRIFT

(11) **EP 2 456 904 B1**
(45) Veröffentlichungstag und Bekanntmachung des Hinweises auf die Patenterteilung: **06.01.2021**
(21) Anmeldenummer: 10747571.7
(22) Anmeldetag: 22.07.2010
(51) Int. Cl.: C23C 14/10, C23C 14/08, G02B 6/132, H01L 23/498, H01L 21/48, C23C 14/30

(54) **VERFAHREN ZUM HERSTELLEN EINER STRUKTURIERTEN BESCHICHTUNG AUF EINEM SUBSTRAT**
METHOD FOR PRODUCING A STRUCTURED COATING ON A SUBSTRATE
PROCÉDÉ DE FABRICATION D'UN REVÊTEMENT STRUCTURÉ SUR UN SUBSTRAT

(30) Priorität: 23.07.2009 DE 102009034532
(43) Veröffentlichungstag der Anmeldung: 30.05.2012
(73) Patentinhaber: MSG Lithoglas AG, 13355 Berlin (DE)
(72) Erfinder: LEIB, Jürgen, 91077 Neunkirchen am Brand (DE); HANSEN, Ulli, 10555 Berlin (DE); MAUS, Simon, 10781 Berlin (DE)
(74) Vertreter: Bittner, Thomas L.
(86) Internationale Anmeldenummer: PCT/DE2010/000856
(87) Internationale Veröffentlichungsnummer: WO 2011/009444

(56) Entgegenhaltungen:
- WO-A2-2007/031317
- DE-A1- 10 222 609
- JP-A- 2009 051 055
- US-A1- 2003 176 002
- US-A1- 2005 175 846
- US-A1- 2006 148 156
- US-A1- 2007 063 211
- US-A1- 2009 097 105
- US-B1- 6 468 703
- US-B2- 7 326 446
- SCHILLER S ET AL: "Plasma-activated high rate evaporation using a low voltage electron beam system", SURFACE AND COATINGS TECHNOLOGY, ELSEVIER BV, AMSTERDAM, NL, vol. 68-69, 1 December 1994 (1994-12-01), pages 788-793, XP027004442, ISSN: 0257-8972 [retrieved on 1994-12-01]
- ZYWITZKI O ET AL: "Structure and properties of Al2O3 layers deposited by plasma activated electron beam evaporation", SURFACE AND COATINGS TECHNOLOGY, ELSEVIER BV, AMSTERDAM, NL, vol. 151-152, 1 March 2002 (2002-03-01), pages 14-20, XP002490674, ISSN: 0257-8972, DOI: 10.1016/S0257-8972(01)01632-2 [retrieved on 2002-04-25]

## Beschreibung

Die Erfindung bezieht sich auf Technologien auf dem Gebiet strukturiert beschichteter Substrate.

### Hintergrund der Erfindung

Ein Verfahren zum Herstellen einer strukturierten Beschichtung auf einer zu beschichtenden Oberfläche eines Substrats ist in dem Dokument DE 102 22 609 B4 beschrieben. Der bekannte Prozess betrifft ein sogenanntes Lift Off-Verfahren, bei dem auf der zu beschichtenden Oberfläche des Substrats eine erste Schicht mit einer negativen Strukturierung aufgebracht wird. Anschließend wird eine zweite Schicht hierauf abgeschieden, um schließlich die erste Schicht mit den hierauf befindlichen Abschnitten der zweiten Schicht wenigstens teilweise zu entfernen. Die strukturierte Beschichtung wird bei dem bekannten Verfahren hergestellt, indem die zweite Schicht, welche ein Aufdampfglasmaterial umfasst, mittels Aufdampfen abgeschieden wird.

Neben dem bekannten Lift Off-Prozess kann eine sogenannte Maskenstrukturierung zum Ausbilden einer strukturierten Beschichtung auf einem Substrat genutzt werden, bei der die strukturierte Beschichtung unter Verwendung einer oder mehrerer Schattenmasken hergestellt wird. Mittels der Schattenmaske werden Bereiche des Substrats von dem abzuscheidenden Material freigehalten.

Die beiden vorgenannten Arten des Ausbildens einer strukturierten Beschichtung auf einem Substrat sind spezielle Ausprägungen einer sogenannten additiven Strukturierung.

Aus dem Dokument US 6,468,703 B1 ist ein Verfahren zum Herstellen eines Farbfilter-Schichtsystems auf einem Substrat bekannt, bei dem zum Abscheiden auf dem Substrat eine Lift Off-Technik genutzt wird. Beim Abscheideprozess wird eine plasmagestützte Vakuumverdampfung eingesetzt. Zur Abscheidung kommen Siliziumdioxid oder Titianoxid.

Aus dem Dokumtent WO 2007/031317 A2 ist ein Verfahren zum Aufbringen einer porösen Glasschicht bekannt. Das Abscheiden erfolgt mittels Elektronenstrahlverdampfung. Das abgeschiedene Aufdampfglas umfasst in einer Zusammensetzung Siliziumdioxid und Aluminiumoxid.

Das Dokument DE 102 22 609 A1 betrifft ein Verfahren zur strukturierten Beschichtung eines Substrats mit zumindest einer zu beschichtenden Oberfläche, wobei eine Schicht abgeschieden wird, welche ein Material mit glasartiger Struktur aufweist.

In dem Dokument US 2005 / 0175846 A1 ist ein Substrat beschrieben, welches eine metallische Oberfläche aufweist, die mit einem Glasmaterial beschichtet wird, das mittels thermischen Verdampfen abgeschieden wird. Das Glasmaterial soll wenigstens ein Zweikomponentensystem mit zumindest zwei Materialien sein.

Im Dokument US 2006 / 0148156 A1 ist eine Transistorstruktur offenbart. In einer Ausführung wird Siliziumnitrid strukturiert abgeschieden.

Dokument EP 0 753 842 A2 betrifft ein Verfahren zum Strukturieren mittels Ätzen von dicken Aluminumoxidschichten. Es werden Dünnfilm-Magnetköpfe hergestellt, die für das Aufzeichnen und das Lesen von magnetischen Übergängen in einem sich bewegenden magnetischen Medium nutzbar sind.

Das Dokument US 2007/0063211 A1 offenbart einen Dünnschichttransistor mit einer Kanalschicht, die aus einem für sichtbares Licht transparenten Oxidhalbleiter mit einem Brechungsindex *nx,* einer auf einer Seite der Kanalschicht angeordneten Gate-Isolierschicht und einer auf der anderen Seite der Kanalschicht angeordneten transparenten Schicht mit einem Brechungsindex *nt* gebildet ist, wobei *nx* > *nt* gilt. Des Weiteren ist ein Dünnfilmtransistor offenbart, der ein Substrat mit einem Brechungsindex no, eine transparente Schicht mit einem Brechungsindex *nt,* die auf dem Substrat angeordnet ist, und eine Kanalschicht mit einem Brechungsindex *nx,* die auf der transparenten Schicht angeordnet ist, aufweist, wobei *nx* > *nt* > *no* gilt.

Das Dokument US 2009/097105 A1 betrifft die Herstellung von optischen Elementen mit einer dünnen, glatten, dichten Beschichtung oder einem Film darauf und ein Verfahren zur Herstellung einer solchen Beschichtung oder eines derartigen Films. Das beschichtete Element hat eine quadratische Oberflächenrauheit kleiner als 1,0 nm. Die Beschichtungsmaterialien umfassen Hafniumoxid oder eine Mischung aus Hafniumoxid und einem anderen Oxidmaterial, beispielsweise Siliziumdioxid. Das Verfahren umfasst die Verwendung einer Reverse Mask, um die Beschichtung oder den Film auf einem rotierenden Substrat abzuscheiden. Das Dokument Schiller et al, Surface and coatings Technology 68-69, S. 788-793 (1994) betrifft plasmaaktivierte Hochgeschwindigkeits-Verdampfung unter Verwendung eines Niederspannungs-Elektronenstrahlsystems.

Im Dokument JP 2009 051055 A sind ein dekoratives Gehäuse und ein entsprechendes Herstellungsverfahren offenbart, bei dem für einen dekorativen Effekt unregelmäßige Reflexions- oder Interferenzfarben durch mehrere winzige Vorsprünge auf einem Gehäusesubstrat aus Harz erzeugt werden. Ein Material, das einer Filmbildung unterzogen werden soll, wird durch eine Vielzahl von Öffnungen zugeführt, die in einer auf dem Gehäusesubstrat angeordneten Maske vorgesehen sind. Ein Filmbildungsprozess wird ausgeführt, um eine Vielzahl von inselförmigen Dünnfilmen auf dem Gehäusesubstrat auszubilden. Anschließend wird die Maskenanordnung in einer planaren Richtung des Gehäusesubstrats bewegt und ein weiterer Filmbildungsprozess ausgeführt, um auf dem Gehäusesubstrat mehrere Vorsprünge aus mehreren laminierten Körpern des inselförmigen Dünnfilms zu bilden.

Weiterer Stand der Technik wird in dem Patentdokument US 2003/176002 A1 offenbart.

### Zusammenfassung der Erfindung

Aufgabe der Erfindung ist es, verbesserte Technologien in Verbindung mit dem Herstellen einer strukturierten Beschichtung auf einem Substrat zu schaffen.

Diese Aufgabe wird erfindungsgemäß durch ein Verfahren nach dem unabhängigen Anspruch 1 gelöst. Vorteilhafte Ausgestaltungen der Erfindung sind Gegenstand von abhängigen Unteransprüchen.

Mit Hilfe der Erfindung ist die Möglichkeit geschaffen, auf effiziente Art und Weise für verschiedene Anwendungszwecke individuell gestaltete Beschichtungen mit Strukturierung auf einem Substrat zu schaffen.

In Verbindung mit den unterschiedlichen Schichtaufdampfmaterialien können sich einzelne oder kombinierte Vorteile ergeben, wodurch je nach Anwendungsfall und verwendetem Schichtaufdampfmaterial unterschiedliche Optimierungen ermöglicht sind. So haben aufgedampfte Schichten aus dem Einkomponentensystem Siliziumdioxid im Vergleich zu Schichten ähnlicher Dicke aus Aufdampfglasmaterial, welches im Stand der Technik verwendet wird, eine höhere optische Transmission, insbesondere im ultravioletten Wellenlängenbereich. Auch ist die Durchbruchspannung für Siliziumdioxid höher. Aluminiumoxid zeichnet sich durch eine hohe Kratzfestigkeit und einen hohen optischen Brechungsindex aus. Es wird insbesondere nicht von Flusssäure angegriffen. Titandioxid hat einen sehr hohen optischen Berechungsindex. Siliziumnitrid weist eine hohe Durchbruchspannung auf und verfügt zusätzlich über einen hohen optischen Brechungsindex im Vergleich zu Aufdampfglas.

Es hat sich überraschend gezeigt, dass mit den angegebenen Schichtaufdampfmaterialien eine strukturierte Beschichtung mittels plasmagestützten thermischen Elektronenstrahlverdampfen möglich ist, obwohl diese Einkomponentensysteme im Vergleich zu Aufdampfglas eine wesentlich höhere Schmelztemperatur aufweisen. Trotz dieses Umstandes gelang es Nachteile zu vermeiden, die bei zu hohen Substrattemperaturen auftreten können. Während die Schmelztemperatur von Borosilikatglas, welches als Aufdampfglasmaterial eingesetzt wird, bei etwa 1300°C liegt, ergeben sich für die hier vorgeschlagenen Aufdampfmaterialien die folgenden Werte: Siliziumdioxid - etwa 1713°C, Aluminiumoxid - etwa 2050°C, Titandioxid - etwa 1843°C und Siliziumnitrid - etwa 1900°C.

Die Nutzung der plasmagestützten thermischen Elektronenstrahlverdampfung des Schichtaufdampfmaterials ermöglicht eine optimierte Schichtabscheidung. Das plasmagestützte thermisehe Verdampfen ist je nach gewünschtem Anwendungsfall individuell veränderbar, um bei der Herstellung der strukturierten Beschichtung gewünschte Schichteigenschaften auszubilden. Mit Hilfe der Plasmaunterstützung können beispielsweise auch die Schichthaftung und intrinsische Druck- oder Zugspannungen in der Schicht gesteuert und optimiert werden. Ferner kann die Stöchiometrie der Aufdampfschicht beeinflusst werden.

Die strukturierte Beschichtung kann ein- oder mehrschichtig ausgeführt sein. Bei einer mehrschichtigen Ausbildung kann vorgesehen sein, wenigstens eine Teilschicht aus einem ersten Aufdampfmaterial sowie wenigstens eine weitere Teilschicht aus einem anderen Aufdampfmaterial abzuscheiden. Beispielsweise kann vorgesehen sein, eine erste Teilschicht aus Siliziumdioxid zu bilden, worauf dann eine Schicht aus Aluminiumoxid gebildet wird.

In einer Ausgestaltung können zusätzlich zu einer oder mehrerer Teilschichten der Beschichtung, die mittels plasmagestützten thermischen Elektronenstrahlverdampfen abgeschieden werden, ein oder mehrere weitere Teilschichten mit Hilfe anderer Herstellungsverfahren gebildet werden, zum Beispiel mittels Sputtern oder mittels CVD-Prozess ("*Chemical Vapor Deposition",* Chemische Gasphasenabscheidung). Diese Herstellungsverfahren sind zum Beispiel auch beim Auftragen von Siliziumnitrid oder Siliziumdioxid nutzbar. Die eine oder die weiteren Teilschichten der strukturierten Beschichtung können vor und / oder nach dem Abscheiden der einen oder der mehreren Teilschichten prozessiert werden.

Die Plasmaunterstützung fördert auch eine hohe Güte der aufgedampften Schicht. So sind eine gute Kompaktierung und hierdurch hermetische Eigenschaften ausbildbar. Es treten wenige Defekte aufgrund des verbesserten Schichtwachstums auf. Das zu beschichtende Substrat muss nicht vorgeheizt werden. Eine solche Beschichtung wird auch als IAD-Kaltbeschichtungsprozess bezeichnet. Ein besonderer Vorteil ist hierbei die hohe Abscheiderate, die erzielt werden kann, wodurch die Prozesszeiten bei der Herstellung insgesamt optimiert werden können. In herkömmlichen Aufdampfverfahren müssen zur Erzielung hoher Schichtgüten die Substrate stark vorgeheizt werden. Dies führt zu einer vermehrten Desorption der kondensierenden Teilchen und verringert damit die erreichbare Aufdampfrate. Die Plasmaunterstützung führt darüber hinaus dazu, dass die Dampfkeule mittels des Plasmastrahls gerichtet werden kann, um ein anisotropes Auftreffen der verdampften Partikel auf der zu beschichtenden Substratoberfläche zu erreichen. Dies hat zur Folge, dass eine Schichtabscheidung ohne sogenannte Links erzielt werden kann. Hierbei handelt es sich um ungewollte Verbindungen zwischen unterschiedlichen Bereichen auf der zu beschichtenden Oberfläche des Substrats.

In bevorzugten Verfahrensgestaltungen können ein oder mehrere der folgenden Verfahrensmerkmale vorgesehen sein. In einer Ausgestaltung erfolgt das plasmagestützte thermische Elektronenstrahlverdampfen mit Aufdampfraten zwischen etwa 20nm/min bis etwa 2µm/min. Es kann vorgesehen sein, ein Sauerstoff-, Stickstoff- und / oder Argonplasma zu verwenden. Alternativ oder ergänzend kann vorgesehen sein, dass dem Verfahrensschritt zum thermischen Verdampfen eine Vorbehandlung zum Aktivieren und / oder Reinigen der zu beschichtenden Oberfläche voraus geht. Die Vorbehandlung kann unter Verwendung eines Plasmas ausgeführt werden, insbesondere eines Sauerstoff-, Stickstoff- und / oder eines Argonplasmas. Vorzugsweise erfolgt das Vorbehandeln in-situ, also unmittelbar in der Beschichtungsanlage vor dem thermischen Verdampfen.

Es kann vorgesehen sein, dass der Schritt zum thermischen Verdampfen des wenigstens einen Schichtaufdampfmaterials einen Schritt zum Co-Verdampfen aus wenigstens zwei Verdampfungsquellen umfasst. Mittels der Co-Verdampfung aus wenigstens zwei Verdampfungsquellen können gleiche oder unterschiedliche Materialien abgeschieden werden.

Es kann vorgesehen sein, dass die strukturierte Beschichtung in einer Richtung senkrecht in einer Richtung senkrecht zur Fläche der zu beschichtenden Oberfläche mit einer nicht einheitlichen Materialzusammensetzung hergestellt wird.

Es kann vorgesehen sein, dass das Herstellen einer strukturierten Beschichtung auf der zu beschichtenden Oberfläche des Substrats mehrfach durchgeführt wird.

Es kann vorgesehen sein, dass die strukturierte Beschichtung auf wenigstens zwei Stellen des Substrats hergestellt wird. Zum Beispiel kann die strukturierte Beschichtung auf der Vorder- und der Rückseite des Substrats hergestellt werden. Die strukturierte Schichtabscheidung auf der Vorder- und der Rückseite kann in zeitlich parallelen oder aufeinanderfolgenden Abscheideprozessen erfolgen.

Es kann vorgesehen sein, dass das Substrat mit einem weiteren Substrat verbunden wird. Das weitere Substrat kann Bestandteil eines Bauelementes ausgewählt aus der folgenden Gruppe von Bauelementen sein: Halbleiter-Bauelement, optoelektronisches Bauelement und mikroelektromechanisches Bauelement.

Es kann vorgesehen sein, dass Strukturen der strukturierten Beschichtung wenigstens teilweise ausgefüllt werden. Zum wenigstens teilweisen Ausfüllen der strukturierten Beschichtung können ein elektrisch leitendes und / oder ein transparentes Material eingesetzt werden.

Es kann vorgesehen sein, dass auf dem Substrat wenigstens ein leitender Bereich hergestellt wird. Mittels des wenigstens einen leitenden Bereiches können zum Beispiel eine oder mehrere Leiterbahnen hergestellt werden auf der zu beschichtenden Oberfläche und / oder der strukturierten Beschichtung.

Auf der strukturierten Beschichtung kann eine Bond-Schicht gebildet werden. Die Bond-Schicht umfasst beispielsweise eine Seed-Schicht für eine nachfolgende Metallisierung und / oder eine Klebstoffschicht

Die strukturierte Beschichtung kann als eine mehrlagige Beschichtung gebildet werden. In einer Ausführungsform ist die mehrlagige Beschichtung mit Schichten aus Siliziumdioxid und einem Aufdampfglasmaterial oder Siliziumdioxid und Aluminiumoxid gebildet, wobei die Teilschicht aus dem Aufdampfglasmaterial oder dem Aluminiumoxid eine Deckschicht auf dem Siliziumdioxid bildet. In diesem Zusammenhang kann vorgesehen sein, zum Herstellen einer oder mehrerer Teilschichten auch andere Abscheidungstechnologien als die thermische Verdampfung zu nutzen. Hierzu gehört zum Beispiel das Sputtern.

Es kann vorgesehen sein, dass die strukturierte Beschichtung mit einer Schichtdicke zwischen etwa 0.05µm und etwa 50µm gebildet wird, bevorzugt mit einer Schichtdicke zwischen etwa 0.1µm und etwa 10µm und weiter bevorzugt mit einer Schichtdicke zwischen etwa 0.5µm und etwa 3µm.

Es kann vorgesehen sein, dass das Substrat beim Abscheiden des wenigstens einen Schichtaufdampfmaterials auf der zu beschichtenden Oberfläche eine Substrattemperatur von höchstens etwa 120°C aufweist, bevorzugt von höchstens etwa 100°C. Diese niedrige Substrattemperatur ist insbesondere vorteilhaft bei der Beschichtung von temperaturempfindlichen Materialien wie zum Beispiel Kunstoffen und Polymerfilmen, beispielsweise Fotolacken, sowie von temperaturempfindlichen Bauteilen, zum Beispiel III/V-Halbleiter-Photodetektoren. Das Nutzen des plasmagestützen thermischen Elektronenstrahlverdampfens ermöglicht in einer Ausgestaltung eine ausreichende Verdichtung der erzeugten Schichten, ohne dass hierzu eine Nachtempern erforderlich ist, wie dieses im Stand der Technik regelmäßig vorgesehen ist.

Als Substrat kann ein Substrat bereitgestellt werden, welches wenigstens eines der folgenden Materialien umfasst: Glas, Metall, Kunststoff, Keramik, anorganischer Isolator, Dielektrikum und ein Halbleitermaterial. Als Halbleitermaterialien können zum Beispiel Silizium oder Galliumarsenid zum Einsatz kommen.

Es kann vorgesehen sein, dass bei der additiven Strukturierung wenigstens einer der folgenden Strukturierungsprozesse ausgeführt wird:
- eine Maskenstrukturierung, bei der die strukturierte Beschichtung unter Verwendung einer Schattenmaske hergestellt wird, und
- eine Strukturierung mittels Negativstruktur, bei der das Herstellen der strukturierten Beschichtung die folgenden Schritte umfasst:
   - Herstellen einer ersten Schicht mit einer negativen Strukturierung auf der zu beschichtenden Oberfläche des Substrats, indem wenigstens ein Schichtmaterial auf der zu beschichtenden Oberfläche des Substrats abgeschieden und ein oder mehrere Teilbereiche der zu beschichtenden Oberfläche mittels Entfernen des abgeschiedenen Schichtmaterials freigelegt werden,
   - Abscheiden einer zweiten Schicht aus dem wenigstens einen Schichtaufdampfmaterial auf der mit der ersten Schicht versehenen Oberfläche des Substrates mittels thermischen Verdampfen des wenigstens einen Schichtaufdampfmaterials und
   - wenigstens teilweises Entfernen der ersten Schicht.

Die Strukturierung mittels Negativstruktur wird auch als Lift Off-Strukturierung oder Lift Off-Prozess bezeichnet. Der Schritt zum wenigstens teilweisen Entfernen der ersten Schicht umfasst in einer Ausgestaltung einen Schritt zum Planarisieren der beschichteten Oberfläche. Weiterhin kann ergänzend oder alternativ ein Schritt zum mechanischen Abtragen vorgesehen sein, beispielsweise mittels Schleifen und / oder Läppen und / oder Polieren. Das Ausbilden der negativen Strukturierung kann in einer Ausführungsform einen Schritt zum strukturierten Aufdrucken einer ersten Beschichtung vorsehen, insbesondere das strukturierte Aufdrucken mittels Siebdruck. Das Herstellen der negativen Strukturierung kann einen Schritt zum lithographischen Strukturieren und / oder zum lithographischen Graustufenstrukturieren umfassen. Auch kann in einer Ausführungsform das negative Strukturieren einen Schritt zum Aufbringen einer fotostrukturierbaren Schicht umfassen. In diesem Zusammenhang kann ein Schritt zum Aufbringen eines Fotolackmaterials vorgesehen sein. Der Schritt zum negativen Strukturieren kann einen Schritt zum Auflösen des abgeschiedenen Schichtmaterials in einem Lösungsmittel umfassen. Der Schritt zum wenigstens teilweisen Entfernen der ersten Schicht kann in einer Weiterbildung einen Schritt zum nasschemischen und / oder trockenchemischen Entfernen umfassen.

Bei der Strukturierung kann mittels Negativstruktur die zweite Schicht als eine nicht geschlossene Schicht mit einem oder mehreren Zugängen zu der ersten Schicht hergestellt-werden.

Bei der Strukturierung kann mittels Negativstruktur die zweite Schicht nachbehandelt werden. Die Nachbehandlung wird beispielsweise nasschemisch und / oder trockenchemisch und / oder mittels Tempern und / oder mittels CMP ("*Chemical Mechanical Polishing*") und / oder mittels eines Schritts zum elektrischen Dotieren der zweiten Schicht ausgeführt. Beim elektrischen Dotieren wird üblicherweise wenigstens ein Dotierungsmaterial in ein Matrixmaterial eingelagert, um die elektrischen Eigenschaften der Schicht zu beeinflussen.

Es kann vorgesehen sein, dass bei der Strukturierung mittels Negativstruktur die zweite Schicht mit schräg zurückfallenden Randflächen gebildet wird. Die
Randflächen der zweiten Schicht stehen dann nicht senkrecht auf der darunterliegenden Schicht sondern sind zur zweiten Schicht hin geneigt.

Bei der Strukturierung kann mittels Negativstruktur die erste Schicht wenigstens teilweise aus einem Fotolackmaterial hergestellt werden. Das Aufbringen des Fotolackmaterials erfolgt in einem Schritt zum Belacken, welcher zum Beispiel mittels Spin-Coating und / oder Aufsprühen und / oder Elektrodepositon und / oder Laminieren ausgeführt wird. In diesem Zusammenhang oder auch in Ausführungsformen, in denen kein Fotolackmaterial verwendet wird, kann der Schritt zum teilweisen Entfernen der ersten Schicht einen Schritt zum Prägen oder Ätzen der ersten Schicht umfassen. Das Aufbringen des Fotolackmaterials kann in einer Ausgestaltung mittels Aufbringen einer Fotolack-Folie erfolgen.

Die erste Schicht aus dem Fotolackmaterial kann bei einer Temperatur von höchstens etwa 150°C vernetzt (Softbake) werden. Hierdurch ist eine besonders schonende Ausführung des Lift Off-Verfahrens ermöglicht.

In Verbindung mit dem beschichteten Substrat sowie dem Halbzeug gelten die im Zusammenhang mit den Verfahren zum Herstellen einer strukturierten Beschichtung auf einem Substrat gemachten Erläuterungen entsprechend.

Bevorzugte Ausgestaltungen des beschichteten Substrats und / oder des Halbzeuges sehen eines oder mehrere der folgenden Merkmale vor. Die eine oder die mehreren mittels plasmagestützten thermischen Elektronenstrahlverdampfen abgeschiedenen Schichten sind vorzugsweise säurebeständig gemäß mindestens der Klasse 2 nach DIN 12116. Die Bezugnahme auf die DIN 12116 erfolgt in analoger Weise. Die zu prüfende Oberfläche wird danach sechs Stunden in Salzsäure (c ≈ 5,6 mol/l) gekocht. Anschließend wird der Gewichtsverlust in mg/100cm² ermittelt. Die Klasse 2 ist gegeben, wenn der halbe Oberflächengewichtsverlust nach sechs Stunden über 0,7 mg/100cm² liegt und höchstens 1,5 mg/100cm² beträgt. Weiter bevorzugt ist die Klasse 1 gegeben, bei der der halbe Oberflächengewichtsverlust nach sechs Stunden höchstens 0,7 mg/100cm² beträgt.

Alternativ oder ergänzend ist eine Laugenbeständigkeit gemäß der Klasse 2, weiter bevorzugt gemäß der Klasse 1 nach DIN 52322 (ISO 695) vorgesehen. Auch hier erfolgt die Bezugnahme analog. Zur Bestimmung der Laugenbeständigkeit werden die Oberflächen drei Stunden einer siedenden wässrigen Lösung ausgesetzt. Die Lösung setzt sich aus gleichen Teilen Natriumhydroxid (c = 1 mol/l) und Natriumcarbonat (c = 0,5 mol/l) zusammen. Die Gewichtsverluste werden ermittelt. Die Klasse 2 ist gegeben, wenn der Oberflächengewichtsverlust nach drei Stunden über 75 mg/100cm² liegt und höchstens 175 mg/100cm² beträgt. Nach Klasse 1 beträgt der Oberflächengewichtsverlust nach drei Stunden höchstens 75 mg/100cm².

In einer Ausführungsform ist vorgesehen, dass die eine oder die mehreren mittels plasmagestützten thermischen Elektronenstrahlverdampfen abgeschiedenen Schichten eine hydrolytische Beständigkeit mindestens der Klasse 2 nach DIN 12111 (ISO 719), bevorzugt nach Klasse 1 aufweisen.

Auch kann eine Lösungsmittelbeständigkeit alternativ oder ergänzend gebildet sein. In einer bevorzugten Ausführungsform weisen die mittels plasmagestützten thermischen Elektronenstrahlverdampfen abgeschiedenen Schichten eine Schichteigenspannung von weniger als +500MPa auf, wobei das positive Vorzeichen eine Druckspannung in der Schicht bezeichnet. Vorzugsweise ist eine Schichteigenspannung zwischen +200MPa und +250MPa sowie - 20MPa und +50MPa hergestellt, wobei das negative Vorzeichen eine Zugspannung in der Schicht bezeichnet.

Ergänzend oder alternativ können die Schichten kratzfest ausgeführt sein mit einer Knoophärte von mindestens HK 0.1/20 = 400 gemäß ISO 9385.

Es kann vorgesehen sein, dass die mittels plasmagestützten thermischen Elektronenstrahlverdampfen abgeschiedenen Schichten sehr gut haften mit lateralen Kräften von größer 100mN auf Silizium bei einem Nano-Indentertest mit einer 10µm Spitze.

Das Verfahren zur Herstellung kann angepasst werden, um eine oder mehrere der vorgenannten Schichteigenschaften auszubilden.

### Beschreibung bevorzugter Ausführungsbeispiele

Die Offenbarung wird im Folgenden anhand von bevorzugten Ausführungsbeispielen unter Bezugnahme auf Figuren einer Zeichnung näher erläutert. Hierbei zeigen:
- Fig. 1: eine schematische Darstellung eines Substrats, auf dem eine strukturierte Schicht mittels plasmagestützten thermischen Elektronenstrahlverdampfen eines Schichtaufdampfmaterials abzuscheiden ist,
- Fig. 2: eine schematische Darstellung des Substrats aus Fig. 1 mit hierauf abgeschiedenem Fotolack, der eine einem Negativbild der abzuscheidenden strukturierten Schicht entsprechende Mikrostrukturierung aufweist, die mittels Lithografie gebildet ist,
- Fig. 3: eine schematische Darstellung des Substrats aus Fig. 2 mit einer nun hierauf abgeschiedenen Schicht aus einem Schichtaufdampfmaterial,
- Fig.4: eine schematische Darstellung des Substrats aus Fig. 3, wobei die Fotolackschicht abgelöst ist,
- Fig.5: ein Halbzeug, bei dem auf einem Substrat, eine Fotolackschicht mit Negativstruktur und eine Aufdampfschicht gebildet sind,
- Fig. 6: ein weiteres Halbzeug, bei dem auf einem Substrat, eine Fotolackschicht mit Negativstruktur und eine Aufdampfschicht gebildet sind,
- Fig. 7: eine schematische Darstellung einer Anordnung, bei der auf einem Substrat mittels mehrfacher additiver Strukturierung strukturierte Aufdampfschichten gebildet sind,
- Fig. 8: eine schematische Darstellung einer Anordnung, bei der auf einem Substrat mittels mehrfacher additiver Strukturierung mehrere Aufdampfschichten abgeschieden sind,
- Fig.9: eine schematische Darstellung einer Anordnung, bei der auf einem Substrat eine strukturierte Beschichtung mittels additiver Strukturierung gebildet ist, wobei ein Zwischenbereich in der strukturierten Beschichtung mit einer Materialfüllung versehen ist,
- Fig. 10: eine schematische Darstellung einer Anordnung, bei der auf einem Substrat eine unstrukturierte und eine strukturierte Aufdampfschicht hergestellt sind,
- Fig. 11: eine schematische Darstellung eines Substratabschnitts,
- Fig. 12: eine schematische Darstellung einer Anordnung, bei der auf einem Substrat eine mittels additiver Strukturierung hergestellte Aufdampfschicht gebildet ist, die mit einer Bond-/Seedschicht versehen ist,
- Fig. 13: die Anordnung aus Fig. 12 von schräg oben,
- Fig. 14: eine schematische Darstellung einer Anordnung, bei der der auf einem Substrat mit dem Negativbild aufgebrachter Fotolack von einer Aufdampfschicht vollständig eingeschlossen ist,
- Fig. 15: die Anordnung nach Fig. 14 nach einer mechanischen Planarisierung,
- Fig. 16: eine schematische Darstellung einer Anordnung, bei der Randflächen von Negativstrukturen eines Fotolackmaterials schräg verlaufen und
- Fig. 17: die Anordnung nach Fig. 16 nach einem Lift Off-Prozess zum Ablösen des Fotolackmaterials.

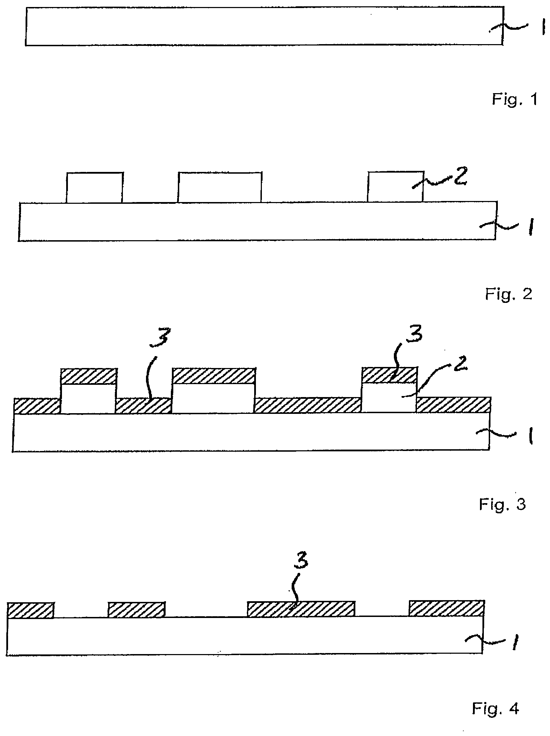

Fig. 1 zeigt eine schematische Darstellung eines Substrats 1, auf welchem eine strukturierte Schicht aus einem Schichtaufdampfmaterial, nämlich Aluminiumoxid, Siliziumdioxid, Siliziumnitrid oder Titandioxid, mittels thermischer Verdampfung abzuscheiden ist, wobei eine plasmagestützte Elektronenstrahlverdampfung genutzt wird. In dem hier beschriebenen Ausführungsbeispiel wird die strukturierte Schicht mit Hilfe eines im Folgenden näher beschriebenen Lift Off-Prozesses hergestellt.

Fig. 2 zeigt eine schematische Darstellung des Substrats 1 aus Fig. 1, auf dem nun mittels bekannter Lithografie ein Negativbild einer für die abzuscheidende Schicht gewünschten Mikrostrukturierung in einem Fotolack 2 aufgebracht ist.

Nun wird mittels thermischer Verdampfung ein Schichtaufdampfmaterial abgeschieden, so dass gemäß Fig. 3 eine Aufdampfschicht 3 entsteht. In einer Ausführung wird hier eine plasmagestützte thermische Elektronenstrahlverdampfung zur Schichtabscheidung verwendet. Die Aufdampfschicht 3 wird ein- oder mehrschichtig ausgeführt.

Das Substrat 1 wird während der Abscheidung der dielektrischen Schicht auf einer Substrattemperatur gehalten, die kleiner als etwa 120°C, vorzugsweise kleiner als etwa 100°C ist. Die Abscheidung des Schichtaufdampfmaterials erfolgt mit Unterstützung eines Plasmas, für welches beispielsweise die Prozessgase Sauerstoff und Argon genutzt werden. In einem Vorbereitungsschritt erfolgt eine Vorreinigung oder Konditionierung der Oberfläche, auf welche das Schichtaufdampfmaterial abzuscheiden ist, mit einem Plasma aus Argon und Sauerstoff. Während der verschiedenen Zeitabschnitte des Abscheidens der Aufdampfschicht 3 wird das genutzte Plasma unterschiedlich eingestellt, insbesondere hinsichtlich seiner Gaszusammensetzung und der Plasmaleistung, um gewünschte Schichteigenschaften in der Aufdampfschicht auszubilden.

Fig. 4 zeigt eine schematische Darstellung des Substrats 1 aus Fig. 3, wobei die Fotolackschicht 2 abgelöst ist.

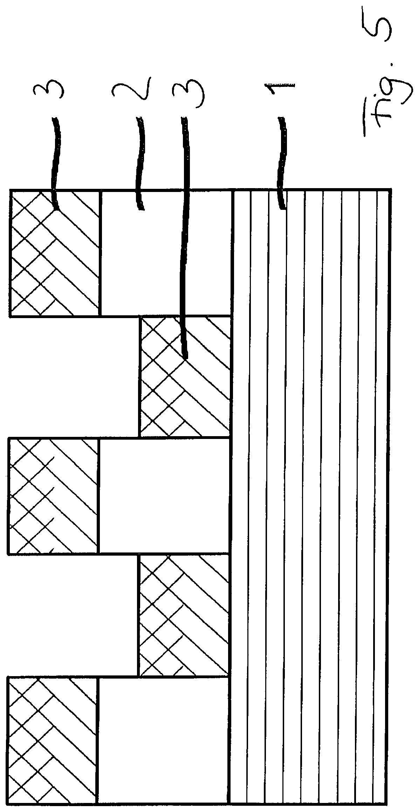

Weitere Ausführungsbeispiele werden nachfolgend unter Bezugnahme auf die Fig. 5 bis 17 erläutert. Hierbei werden für gleiche Merkmale dieselben Bezugszeichen wie in den Fig. 1 bis 4 verwendet.

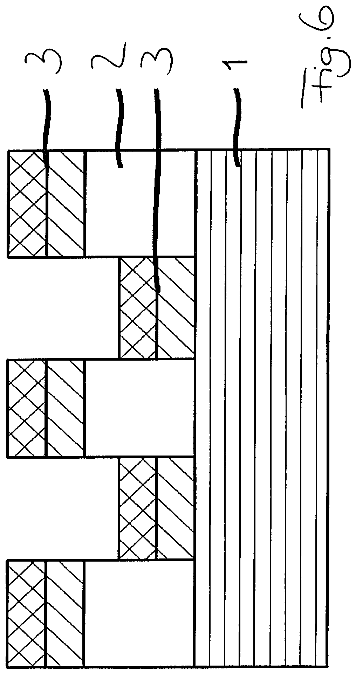

Wird die thermische Verdampfung plasmagestützt durchgeführt, ist ein entsprechender Material- und Eigenschaftsgradient über die gezielte Variation von Plasmaparametern zu erzielen. So kann zum Beispiel eine unterschiedliche Kompaktierung innerhalb eines Schichtaufdampfmaterials erzielt werden, um zum Beispiel den abschließenden Bereich hermetisch zu gestalten. Der Material- und Eigenschaftsgradient kann graduell in Form eines fließenden Übergangs (vgl. Fig. 5) oder abrupt mittels schlagartigem Ändern des abgeschiedenen Aufdampfmaterials, zum Beispiel das Aufbringen eines weiteren Materials, welches auch mit Hilfe eines anderen Verfahren abscheidbar ist, oder schlagartigem Ändern der Plasmaparameter hergestellt werden (Fig. 6). Beispielsweise können so mittels mehrmaligen Aufbringens von Schichten mit unterschiedlichem Brechungsindex strukturierte Antireflex-Beschichtungen hergestellt werden.

Die Fig. 5 und 6 zeigen jeweils ein Halbzeug, bei dem auf dem Substrat 1, die Fotolackschicht 2 mit der Negativstruktur und die Aufdampfschicht 3 gebildet sind, wobei letztere mit einem graduellen oder fließenden Materialübergang (vgl. Fig. 5) oder einer einem abrupten Materialübergang (vgl. Fig. 6) gebildet ist. Gemäß Fig. 3 kann mit Hilfe eines Abhebeprozesses die strukturierte Aufdampfschicht freigelegt werden.

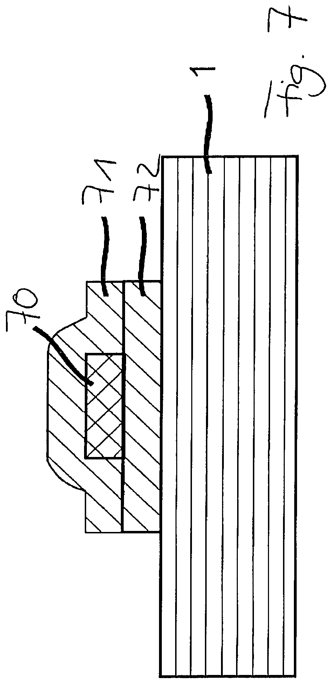

Fig. 7 zeigt eine schematische Darstellung einer Anordnung, bei der auf dem Substrat 1 mittels mehrfacher additiver Strukturierung strukturierte Aufdampfschichten 70, 71, 72 gebildet sind. Mehrfach wurde ein Lift Off-Prozess durchgeführt. In einem Ausführungsbeispiel wird auf dem Substrat 1 zuerst die strukturierte Schicht 72 mit einem niedrigen optischen Brechungsindex abgeschieden, die in einer Ausführungsform aus Siliziumdioxid (SiO₂) ist. Anschließend folgt die strukturierte Abscheidung der Aufdampfschicht 70 aus einem Schichtaufdampfmaterial, welches einen höheren optischen Brechungsindex als das Schichtaufdampfmaterial in der Schicht 72 aufweist, zum Beispiel Aluminiumoxid (Al₂O₃). Mittels erneuter strukturierter Abscheidung wird schließlich die Aufdampfschicht 71 abgeschieden, zum Beispiel aus einem Material, welches über einen niedrigeren optischen Brechungsindex als das Schichtaufdampfmaterial in der Schicht 70 verfügt, zum Beispiel Siliziumdioxid. Die Aufdampfschicht 70 wird hierbei vollständig eingeschlossen, wodurch zum Beispiel ein Lichtwellenleiter ausbildbar ist.

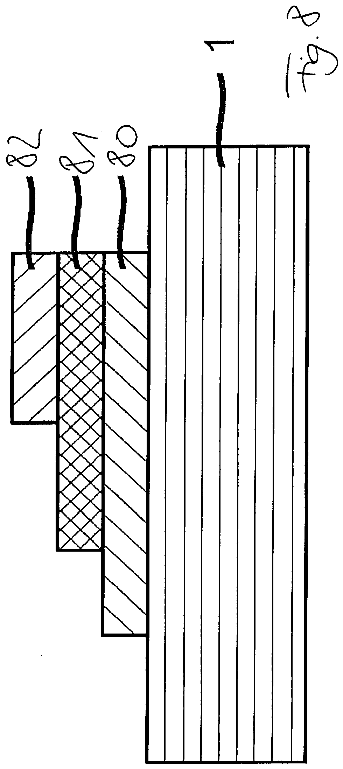

Fig. 8 zeigt eine schematische Darstellung einer Anordnung, bei der auf dem Substrat 1 mittels mehrfacher additiver Strukturierung mehrere Aufdampfschichten 80, 81, 82 abgeschieden sind, wodurch eine strukturierte Beschichtung gebildet ist. Die mehrlagige Ausbildung der strukturierten Beschichtung auf dem Substrat 1 ermöglicht in einer Ausführungsform zum Beispiel mehrlagige diffraktive Elemente. Von den mehreren Aufdampfschichten 80, 81, 82 können ein, zwei oder sogar alle drei Aufdampfschichten aus demselben Material sein. Es kann jedoch auch vorgesehen sein, dass zwei verschiedene oder sogar drei verschiedene Schichtaufdampfmaterialien verwendet werden, um die mehreren Aufdampfschichten 80, 81, 82 herzustellen. In einer alternativen Ausgestaltung kann vorgesehen sein, dass ein oder zwei Schichten der mehrlagigen Beschichtung auf dem Substrat 1 nicht mittels thermischen Verdampfen sondern mit Hilfe anderer Herstellungsverfahren erzeugt werden zum Beispiel mittels Sputtern oder CVD. Zudem kann eine der mehreren Aufdampfschichten 80, 81, 82 eine Metallisierungslage sein.

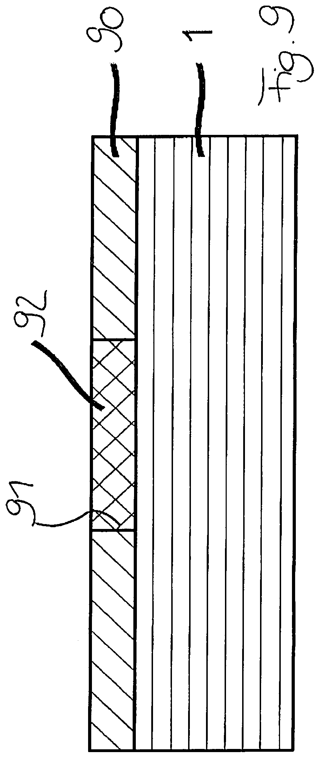

Fig. 9 zeigt eine schematische Darstellung einer Anordnung, bei der auf dem Substrat 1 eine strukturierte Beschichtung 90 mittels additiver Strukturierung gebildet ist, wobei ein Zwischenbereich 91 in der strukturierten Beschichtung 90 mit einer Materialfüllung 92 versehen ist, die beispielsweise mittels Abscheiden eines elektrisch leitenden und / oder eines optisch transparenten Materials hergestellt ist. Zum Beispiel kann so eine "vergrabene" Leiterbahn aus einem elektrisch leitenden Material gebildet werden. Hierzu wird auf die strukturierte Beschichtung 90 und in den Zwischenbereich 91 mittels Sputtern eine dünne Seed-Schicht aufgebracht, zum Beispiel aus TiW/Cu. Hierauf folgend wird eine Fotolackmaskierung ausgeführt, die über den zu verfüllenden Zwischenbereich 91 frei strukturiert ist. Anschließend wird in einem elektrogalvanischen Prozess Kupfer bis zur Oberkante der strukturierten Beschichtung 90 abgeschieden. Mittels Freilegen der Maskierung und Entfernen der Seed-Schicht auf der strukturierten Beschichtung 90, die mittels thermischen Verdampfen gebildet ist, werden die zuvor auf dem Substrat 1 freiliegende Bereiche, insbesondere der Zwischenbereich 91, mit einer Leiterbahn aus Kupfer verfüllt.

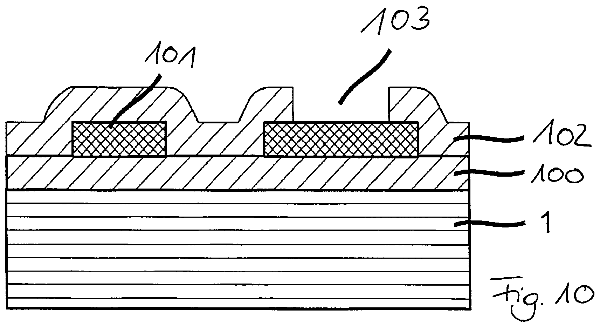

Fig. 10 zeigt eine schematische Darstellung einer Anordnung, bei der auf dem Substrat 1 eine unstrukturierte Aufdampfschicht 100 hergestellt ist. Hierauf gebildete Leiterbahnen 101 aus einem elektrisch leitenden Material werden mittels einer strukturierten Aufdampfschicht 102 wenigstens teilweise bedeckt, die mit Hilfe additiver Strukturierung hergestellt wird. Über eine Öffnung 103 in der strukturierten Aufdampfschicht 102 ist eine elektrische Kontaktierung ermöglicht.

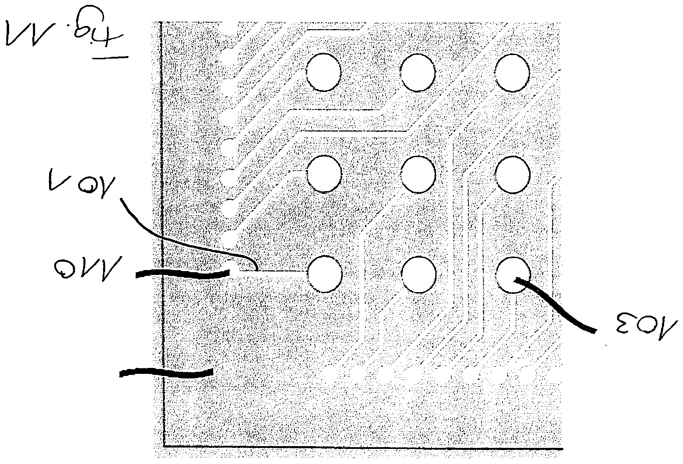

Fig. 11 zeigt eine schematische Darstellung eines Substratabschnitts, wobei gezeigt ist, wie die bei der Anordnung in Fig. 10 elektrische Leiterbahnen für eine Umverdrahtung genutzt werden können. Peripher angeordnete Kontaktpads 110 sind über Leiterbahnen 111 mit größeren, flächig angeordneten Kontaktbereichen 112 verdrahtet. Die Metallstrukturen sind auf einer unstrukturierten Basisschicht aufgebracht (vgl. Fig. 10) und werden von einer nur über den großen Kontaktbereichen 112 geöffneten Schicht abgedeckt. Eine solche Anordnung ist insbesondere in Verbindung mit der sogenannten Flip-Chip-Montage von Bauteilen vorteilhaft.

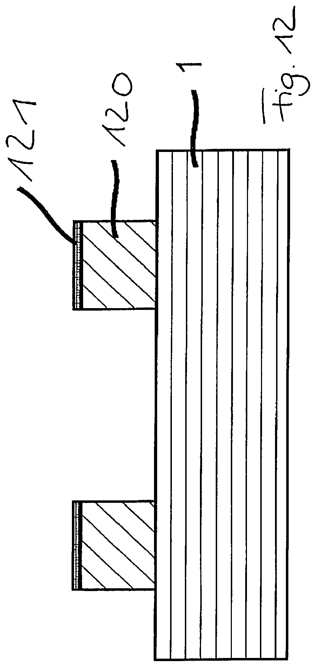

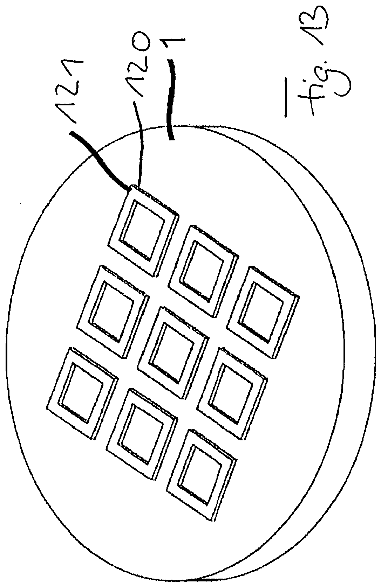

Fig. 12 zeigt eine schematische Darstellung einer Anordnung, bei der auf dem Substrat 1 eine mittels additiver Strukturierung hergestellte Aufdampfschicht 120 gebildet ist, auf welcher eine Seed- oder Bond-Schicht 121 aufgebracht ist. Beispielsweise kann es sich bei der Seed- oder Bond-Schicht um eine Klebeschicht handeln, mit der die Anordnung mit dem Substrat 1 auf ein weiteres Substrat (nicht dargestellt) geklebt wird. So kann zwischen einem ersten Substrat mit einer Rahmenstruktur und einem zweiten Substrat ein geschlossener Hohlraum (*Cavity*) gebildet werden. Genutzt werden kann dieses beispielsweise zum Verkapseln von optisch aktiven Flächen auf dem Substrat 1. Auch kann ein selektives Aufbringen einer Seed-Schicht auf einer solchen Rahmenstruktur vorgesehen sein, wobei die Rahmenstruktur zum Beispiel aus Kupfer ist. Beim Verbinden der beiden Substrate kann das zweite Substrat über metallisierte Bereiche zum Beispiel aus Zinn verfügen. Beide Substrate können dann über einen sogenannten eutektischen Bond gefügt werden. Fig. 13 zeigt die Anordnung aus Fig. 12 von schräg oben.

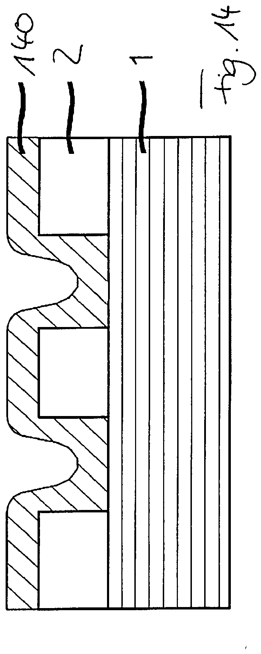

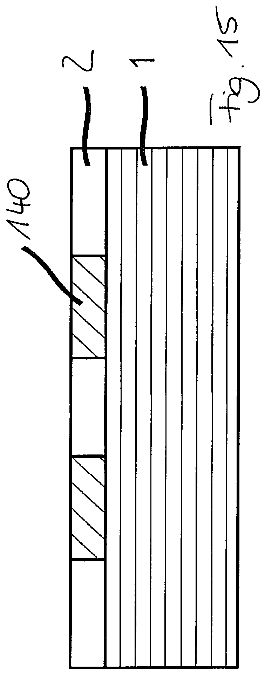

Fig. 14 zeigt eine schematische Darstellung einer Anordnung, bei der der auf dem Substrat 1 mit dem Negativbild aufgebrachte Fotolack 2 von einer Aufdampfschicht 140 vollständig eingeschlossen ist. In einem hierauf folgenden Verfahrensschritt wird der Schichtverbund auf dem Substrat 1 mittels mechanischer Bearbeitung, zum Beispiel mittels Läppen, Schleifen und / oder Polieren, planarisiert. Das Ergebnis zur mechanischen Bearbeitung ist in Fig. 15 gezeigt.Durch Herauslösen der restlichen Maskierung 2 kann die strukturierte Aufdampfschicht 140 freigelegt werden.

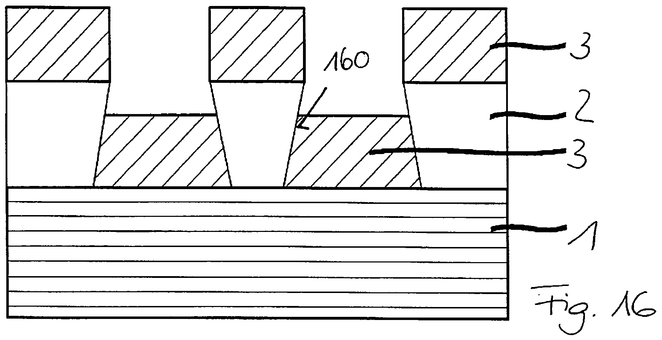

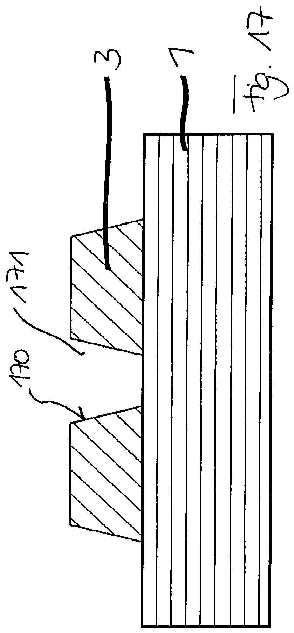

Fig. 16 zeigt eine schematische Darstellung einer Anordnung, bei der Randflächen 160 der Negativstrukturen des Fotolackmaterials 2 schräg verlaufen, sodass gemäß Fig. 17 Randflächen 170 der strukturierten Beschichtung 3 ebenfalls schräg gebildet werden, aber mit umgekehrter Neigung. Die Anordnung nach Fig. 17 entsteht im Ergebnis des Ablösens des Fotolackmaterials 2. Die Randflächen 170 verfügen über einen positiven Flankenwinkel. Eine solche Ausbildung der strukturierten Beschichtung 3 ist zum Beispiel vorteilhaft für eine nachfolgende Metallisierung, bei der ein oder mehrere Leiterbahnen (nicht dargestellt) über die Randflächen 170 geführt werden.

In Verbindung mit den vorangehend beschriebenen Ausführungsbeispielen wurde auf die additive Strukturierung Bezug genommen, die wahlweise mittels Lift Off-Prozess ausgeführt wird. Alternativ hierzu kann die additive Strukturierung unter Verwendung einer Schattenmasken-Technologie ausgeführt werden. Eine oder mehrere Masken werden hierbei in üblicher Weise zur Abschattung von Bereichen auf dem zu beschichtenden Substrat genutzt, die von dem Aufdampfschichtmaterial frei bleiben sollen. Auch in Verbindung mit der Schattenmasken-Technologie ist eine mehrfache Anwendung zum Abscheiden mehrlagiger strukturierter Beschichtungen möglich.

## Patentansprüche

1. Verfahren, umfassend die folgenden Schritte:
- Bereitstellen eines Substrats (1) mit einer zu beschichtenden Oberfläche und
- Herstellen einer strukturierten Beschichtung auf der zu beschichtenden Oberfläche des Substrats (1), die Beschichtung bestehend aus
- einer ersten Schicht (72), die auf dem Substrat (1) abgeschieden wird,
- einer zweiten Schicht (70), die auf der ersten Schicht (72) abgeschieden wird und
- einer dritten Schicht (71), die auf der zweiten Schicht (70) abgeschieden wird,
wobei
- die erste Schicht (72), die zweite Schicht (70) und die dritte Schicht (71) jeweils hergestellt werden, indem jeweils ein Schichtaufdampfmaterial, nämlich das Einkomponentensystem bestehend aus Aluminiumoxid, Siliziumdioxid, Titandioxid, oder Siliziumnitrid, mittels thermischen Verdampfen des Schichtaufdampfmaterials unter Verwendung einer additiven Strukturierung abgeschieden wird,
- das Schichtaufdampfmaterial der zweiten Schicht (70) einen höheren optischen Brechungsindex als das Schichtaufdampfmaterial der ersten Schicht (72) und als das Schichtaufdampfmaterial der dritten Schicht (71) aufweist, **dadurch gekennzeichnet, dass**
- die zweite Schicht (70) vollständig von der ersten Schicht (70) und der dritten Schicht (71) eingeschlossen ist, wodurch ein Lichtwellenleiter ausgebildet ist, und
- das thermische Verdampfen als plasmagestütztes thermisches Elektronenstrahlverdampfen ausgeführt wird.

2. Verfahren nach mindestens einem der vorangehenden Ansprüche, dadurch **gekennzeichne**t, dass auf dem Substrat (1) wenigstens ein leitender Bereich hergestellt wird.

3. Verfahren nach Anspruch 1 oder 2, **dadurch gekennzeichnet, dass** die strukturierte Beschichtung mit einer Schichtdicke zwischen etwa 0.05µm und etwa 50µm gebildet wird, bevorzugt mit einer Schichtdicke zwischen etwa 0.1µm und etwa 10µm und weiter bevorzugt mit einer Schichtdicke zwischen etwa 0.5µm und etwa 3µm.

4. Verfahren nach mindestens einem der vorangehenden Ansprüche, **dadurch gekennzeichnet, dass** das Substrat (1) beim Abscheiden des Schichtaufdampfmaterials auf der zu beschichtenden Oberfläche eine Substrattemperatur von höchstens etwa 120°C aufweist, bevorzugt von höchstens etwa 100°C.

5. Verfahren nach mindestens einem der vorangehenden Ansprüche, **dadurch gekennzeichnet, dass** als Substrat (1) ein Substrat bereitgestellt wird, welches wenigstens eines der folgenden Materialien umfasst: Glas, Metall, Kunststoff, Keramik, anorganischer Isolator, Dielektrikum und ein Halbleitermaterial.

6. Verfahren nach mindestens einem der vorangehenden Ansprüche, **dadurch gekennzeichnet, dass** bei der additiven Strukturierung wenigstens einer der folgenden Strukturierungsprozesse ausgeführt wird:
- eine Maskenstrukturierung, bei der die strukturierte Beschichtung unter Verwendung einer Schattenmaske hergestellt wird, und
- eine Strukturierung mittels Negativstruktur, bei der das Herstellen der strukturierten Beschichtung die folgenden Schritte umfasst:
- Herstellen einer ersten Schicht (72) mit einer negativen Strukturierung auf der zu beschichtenden Oberfläche des Substrats (1), indem wenigstens ein Schichtmaterial auf der zu beschichtenden Oberfläche des Substrats (1) abgeschieden und ein oder mehrere Teilbereiche der zu beschichtenden Oberfläche mittels Entfernen des abgeschiedenen Schichtmaterials freigelegt werden,
- Abscheiden einer zweiten Schicht (70) aus dem Schichtaufdampfmaterial auf der mit der ersten Schicht (72) versehenen Oberfläche des Substrates (1) mittels thermischen Verdampfen des Schichtaufdampfmaterials und
- wenigstens teilweises Entfernen der ersten Schicht (72).

7. Verfahren nach Anspruch 6, **dadurch gekennzeichnet, dass** bei der Strukturierung mittels Negativstruktur die zweite Schicht (70) als eine nicht geschlossene Schicht mit einem oder mehreren Zugängen zu der ersten Schicht (72) hergestellt wird.

8. Verfahren nach mindestens einem der Ansprüche 6 oder 7, **dadurch gekennzeichnet, dass** bei der Strukturierung mittels Negativstruktur die erste Schicht (72) wenigstens teilweise aus einem Fotolackmaterial hergestellt wird.

## Claims

1. A method comprising the following steps:
- providing a substrate (1) having a surface to be coated and
- producing a structured coating on the surface to be coated of the substrate (1), the coating consisting of
- a first layer (72), which is deposited on the substrate (1),
- a second layer (70), which is deposited on the first layer (72), and
- a third layer (71), which is deposited on the second layer (70),
wherein
- the first layer (72), the second layer (70), and the third layer (71) are each produced by depositing an evaporation coating material, specifically the one-component system consisting of aluminium oxide, silicon dioxide, titanium dioxide or silicon nitride, by means of thermal evaporation of the evaporation coating material using an additive structuring,
- the evaporation coating material of the second layer (70) has a higher optical refractive index than the evaporation coating material of the first layer (72) and than the evaporation coating material of the third layer (71), **characterised in that**
- the second layer (70) is enclosed fully by the first layer (70) and the third layer (71), whereby an optical waveguide is produced, and
- the thermal evaporation is performed as a plasma-assisted thermal electron beam evaporation.

2. The method according to at least one of the preceding claims, **characterised in that** at least one conductive region is produced on the substrate (1).

3. The method according to claim 1 or 2, **characterised in that** the structured coating is formed with a layer thickness of between approximately 0.05 µm and approximately 50 µm, preferably with a layer thickness of between approximately 0.1 µm and approximately 10 µm, and furthermore preferably with a layer thickness of between approximately 0.5 µm and approximately 3 µm.

4. The method according to at least one of the preceding claims, **characterised in that** the substrate (1), whilst the evaporation coating material is being deposited on the surface to be coated, has a substrate temperature of at most approximately 120°C, preferably of at most approximately 100°C.

5. The method according to at least one of the preceding claims, **characterised in that** a substrate which comprises at least one of the following materials: glass, metal, plastic, ceramic, inorganic insulator, dielectric and a semiconductor material is provided as substrate (1).

6. The method according to at least one of the preceding claims, **characterised in that**, during the additive structuring, at least one of the following structuring processes is carried out:
- a mask structuring, in which the structured coating is produced using a shadow mask, and
- a structuring by means of negative structure, in which the production of the structured coating comprises the following steps:
- producing, on the surface to be coated of the substrate (1), a first layer (72) with a negative structuring by depositing at least one coating material on the surface to be coated of the substrate (1) and by exposing one or more portions of the surface to be coated by removal of the deposited coating material,
- depositing a second layer (70) of the evaporation coating material on the surface of the substrate (1) provided with the first layer (72) by means of thermal evaporation of the evaporation coating material, and
- at least partially removing the first layer (72).

7. The method according to claim 6, **characterised in that**, when producing the structuring by means of negative structure, the second layer (70) is produced as a non-closed layer with one or more accesses to the first layer (72).

8. The method according to at least one of claims 6 or 7, **characterised in that**, when producing the structuring by means of negative structure, the first layer (72) is produced at least in part from a photoresist material.

## Revendications

1. Procédé, comprenant les étapes suivantes, consistant à :
- mettre à disposition un substrat (1) pourvu d'une surface à revêtir et
- créer un revêtement structuré sur la surface à revêtir du substrat (1), le revêtement consistant dans
- une première couche (72), que l'on dépose sur le substrat (1),
- une deuxième couche (70), que l'on dépose sur la première couche (72), et
- une troisième couche (71), que l'on dépose sur la deuxième couche (70),
- la première couche (72), la deuxième couche (70) et la troisième couche (71) étant créées chacune en ce que l'on dépose chaque fois une matière à vaporiser en couche, à savoir le système monocomposant constitué de oxyde d'aluminium, de dioxyde de silicium, de dioxyde de titane ou de nitrure de silicium au moyen d'une vaporisation thermique de la matière à vaporiser en couches, en utilisant une structuration additive,
- la matière à vaporiser en couche de la deuxième couche (70) faisant preuve d'un indice de réfraction plus élevé que la matière à vaporiser en couche de la première couche (72) et que la matière à vaporiser en couche de la troisième couche (71), **caractérisé en ce que**
- la deuxième couche (70) est totalement incluse dans la première couche (70) et la troisième couche (71), ce qui a pour effet de former une fibre optique, et
- la vaporisation thermique est réalisée sous la forme d'un procédé thermique d'évaporation par faisceaux d'électrons et par action de plasma.

2. Procédé selon au moins l'une quelconque des revendications précédentes, **caractérisé en ce que** l'on créé sur le substrat (1) au moins une zone conductrice.

3. Procédé selon la revendication 1 ou 2, **caractérisé en ce que** l'on forme le revêtement structuré avec une épaisseur de couche comprise entre approximativement 0.05 µm et approximativement 50 µm, de préférence avec une épaisseur de couche comprise entre approximativement 0.1 µm et approximativement 10 µm et de manière plus préférentielle, avec une épaisseur de couche comprise entre approximativement 0.5 µm et approximativement 3 µm.

4. Procédé selon au moins l'une quelconque des revendications précédentes, **caractérisé en ce que** lors du dépôt de la matière à vaporiser en couches sur la surface à revêtir, le substrat (1) présente une température de substrat d'un maximum d'approximativement 120 °C, de préférence, d'un maximum d'approximativement 100 °C.

5. Procédé selon au moins l'une quelconque des revendications précédentes, **caractérisé en ce que** l'on met à disposition en tant que substrat (1) un substrat, lequel comprend au moins l'une des matières suivantes : le verre, le métal, la matière plastique, la céramique, l'isolateur inorganique, la matière diélectrique et une matière semi-conductrice.

6. Procédé selon au moins l'une quelconque des revendications précédentes, **caractérisé en ce que** lors de la structuration additive, l'on réalise au moins l'un des processus de structuration suivants :
- une structuration par masquage, lors de laquelle l'on créé le revêtement structuré en utilisant un masque d'ombre, et
- une structuration au moyen d'une structure négative, lors de laquelle la création du revêtement structuré comprend les étapes suivantes, consistant à :
- créer une première couche (72) pourvue d'une structuration négative sur la surface à revêtir du substrat (1), **en ce que** l'on dépose au moins une matière de couche sur la surface à revêtir du substrat (1) et l'on met à nu une ou plusieurs zones partielles de la surface à revêtir en retirant la matière de couche déposée,
- déposer une deuxième couche (70) de la matière à vaporiser en couche sur la surface du substrat (1) munie de la première couche (72), au moyen d'une vaporisation thermique de la matière à vaporiser en couches et
- retirer au moins partiellement la première couche (72).

7. Procédé selon la revendication 6, **caractérisé en ce que** lors de la structuration au moyen d'une structure négative, l'on créé la deuxième couche (70) sous la forme d'une couche non fermée, pourvue d'un ou de plusieurs accès à la première couche (72).

8. Procédé selon au moins l'une quelconque des revendications 6 ou 7, **caractérisé en ce que** lors de la structuration au moyen d'une structure négative, l'on créé la première couche (72) au moins partiellement en une résine photosensible.
